(19) Europäisches Patentamt
European Patent Office
Office européen des brevets

(11) **EP 1 775 739 A1**

(12) **EUROPEAN PATENT APPLICATION**

(43) Date of publication:
**18.04.2007 Bulletin 2007/16**

(51) Int Cl.:
*H01F 6/06* (2006.01)   *H01F 41/06* (2006.01)
*G01R 33/3815* (2006.01)

(21) Application number: **06118738.1**

(22) Date of filing: **10.08.2006**

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK YU**

(30) Priority: **05.09.2005 JP 2005256760**

(71) Applicant: **Kabushiki Kaisha Kobe Seiko Sho (Kobe Steel, Ltd.)**
**Kobe-shi,**
**Hyogo 651-8585 (JP)**

(72) Inventors:
• **Zaitsu, Kyoji**
**Hyogo**
**Hyogo 651-2271 (JP)**

• **Miyatake, Takayuki**
**Hyogo**
**Hyogo 651-2271 (JP)**
• **Miyazaki, Takayoshi**
**Hyogo**
**Hyogo 651-2271 (JP)**
• **Ozaki, Osamu**
**Hyogo**
**Hyogo 651-2271 (JP)**
• **Fukuyama, Kazuhiro**
**Hyogo**
**Hyogo 651-2271 (JP)**

(74) Representative: **TBK-Patent**
**Bavariaring 4-6**
**80336 München (DE)**

(54) **Bobbin for superconducting coil, and superconducting solenoid coil**

(57)    A bobbin for a superconducting coil includes a cylindrical drum, and a tapered portion extending from each end of the drum. A superconducting wire or a precursor of the superconducting wire shaped like a tape is helically wound around the drum in multiple layers. The tapered portion has a tapered surface that is inclined at an arbitrary angle.

## FIG. 1

**Description**

BACKGROUND OF THE INVENTION

1. Field of the Invention

The present invention relates to a bobbin around which a tape-like superconducting wire is helically wound in multiple layers to form a superconducting coil, and to a solenoid coil formed by winding a tape-like superconducting wire around the bobbin in multiple layers. More particularly, the present invention relates to a bobbin that has a cylindrical drum and that allows a tape-like superconducting wire to be helically wound around the bobbin in multiple layers to form a solenoid coil and to be wound back at both ends of the drum by a simple winding operation while minimizing distortion of the wire, and to a solenoid coil formed with the bobbin.

2. Description of the Related Art

As superconducting wires, a metal superconducting wire of, for example, NbTi or Nb$_3$Sn and an oxide superconducting wire of, for example, bismuth oxide and yttrium oxide are known. The former metal superconducting wire is shaped like a thickish belt with a circular or rectangular cross section. The latter oxide superconducting wire is typically shaped like a thin tape because there is a need to adjust directivity of oxide crystals by rolling or by other methods.

Pancake winding and solenoid winding are known as methods for winding a superconducting wire to form a superconducting coil. Heretofore, pancake winding has been used dominantly. A pancake winding method is disclosed in, for example, Japanese Unexamined Patent Application Publication No. 2001-332415. In recent years, however, the use of solenoid coils mainly as superconducting coils for analysis and medical care, such as nuclear magnetic resonance analysis and magnetic resonance imaging, has been increasing. This is because a highly uniform magnetic field can be obtained easily. A solenoid winding method is disclosed in, for example, Japanese Unexamined Patent Application Publication No. 10-289817.

A wind-and-react technique and a react-and-wind technique are used to form a solenoid coil with such a superconducting wire. In the wind-and-react technique, superconductivity is given to a wire after the wire has been wound around a bobbin. In contrast, in the react-and-wind technique, a wire is wound around a bobbin after superconductivity has been given to the wire. When an oxide superconducting coil is formed by the wind-and-react technique, since a wire is wound into a coil and is then subjected to oxidation heating to become superconductive, deterioration of the superconductivity due to distortion of the wire is suppressed. On the other hand, since the wire closely wound into a coil is heated while supplying oxygen thereto from the outside, oxygen easily runs short inside the coil. Moreover, it has been pointed out that insulating the coil is difficult because heating is performed at high temperature after winding. For this reason, as taught in the above-described publication Japanese Unexamined Patent Application Publication H10-289817, a method has been proposed in which an oxidizing gas is also supplied from the inside of the coil through vent holes provided in a drum of the bobbin during oxidation heating after winding.

In contrast, in the react-and-wind technique, a sufficient amount of oxygen can be supplied to make the wire superconductive. However, when a superconducting wire is helically (solenoidally) wound to form a plurality of layers, it is seriously distorted at a winding-back position (where the wire is wound back from a first layer to a second layer, from the second layer to a third layer, from the third layer to a fourth layer, ...). This distortion deteriorates superconductivity. For this reason, it seems that various methods have been proposed to minimize distortion of the wire at the winding-back position, although they are not specifically described in documents. However, as far as the present inventors know, there has not been proposed a method that satisfactorily reduces distortion at the winding-back position and that facilitates winding-back operation.

SUMMARY OF THE INVENTION

In view of the above-described circumstances, it is an object of the present invention to provide a bobbin around which a tape-like superconducting wire is helically wound in multiple layers to form a solenoid coil, and which allows the superconducting wire to be easily and smoothly wound back at an end of a drum from a certain layer to a subsequent layer while minimizing distortion of the superconducting wire, regardless of whether the superconducting wire is formed of metal or oxide or whether the solenoid coil is formed by a react-and-wind technique or a wind-and-react technique. It is another object of the present invention to provide a compact solenoid coil formed with the bobbin while minimizing deterioration of superconductivity.

In order to solve the above-described problems, a bobbin for a superconducting coil according to an aspect of the present invention includes a cylindrical drum around which a tape-like wire (a superconducting tape or a precursor of the superconducting tape) is helically wound in multiple layers; and a tapered portion extending from each end of the drum and having a tapered surface that is inclined at an arbitrary angle.

The tapered surface may be inclined at a constant angle, or may include two or more inclined faces such that the inclination angle increases stepwise. Alternatively, the tapered surface may be a curved face such that the inclination angle continuously increases in a stepless manner.

A solenoid coil according to another aspect of the present invention includes a tape-like superconducting wire helically wound in multiple layers around the drum of the above-described bobbin. The tape-like wire is wound back along the tapered portion of the bobbin by being wound in contact with the tapered portion, and a helical winding angle of the tape-like wire is changed from $\alpha$ to $-\alpha$ by a winding-back operation.

The bobbin of the present invention has an extremely simple structure in which the tapered portion having the tapered surface inclined at an arbitrary angle is provided at each end of the drum. With this structure, a tape-like superconducting wire or a precursor thereof can be easily, smoothly, and helically wound to form a subsequent layer with little distortion simply by being wound back along the tapered portions.

In addition, since distortion caused at the winding-back position can be minimized, as described above, a solenoid coil having superior superconductivity can be provided with high productivity and at low cost, regardless of whether it is formed by the react-and-wind technique or the wind-and-react technique.

BRIEF DESCRIPTION OF THE DRAWINGS

FIG. 1 is a front view of a bobbin according to an embodiment of the present invention;
FIG. 2 is a conceptual view showing a state in which a tape wire is helically wound around the bobbin shown in FIG. 1;
FIG. 3 is a front view of a bobbin according to another embodiment of the present invention;
FIG. 4 is a front view of a bobbin according to a further embodiment of the present invention;
FIG. 5 is a front view of a bobbin according to a still further embodiment of the present invention;
FIG. 6 is a front view of a bobbin according to a still further embodiment of the present invention;
FIG. 7 is a front view of a bobbin used in a first example;
FIG. 8 is an explanatory view of a tape wire used in the first example;
FIG. 9 is a front view of a bobbin used in a second example; and
FIG. 10 is an explanatory view of a tape wire used in the second example.

DESCRIPTION OF THE PREFERRED EMBODIMENTS

A bobbin according to the present invention includes a cylindrical drum, and is used to form a superconducting solenoid coil. A tape-like (sheet-like) superconducting wire or a precursor thereof is helically wound around the drum in multiple layers. A tapered portion extends from each end of the drum of the bobbin, and has a tapered surface that is inclined at an arbitrary angle such that the diameter of the tapered portion decreases toward the tip thereof.

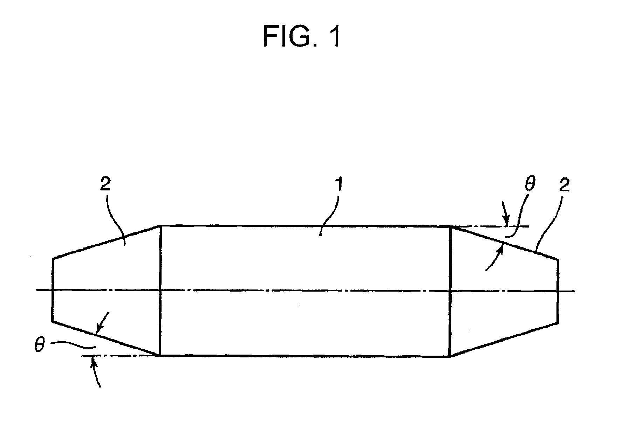

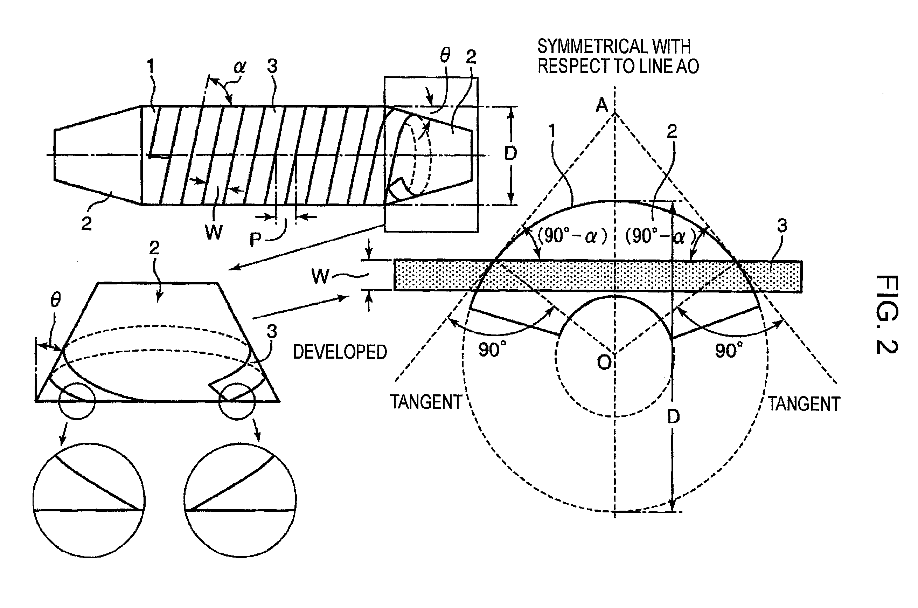

FIG. 1 is a front view of a bobbin according to an embodiment of the present invention. As shown in FIG. 1, a tapered portion 2 extends from each end of a cylindrical drum 1, and has a tapered surface that is inclined at an arbitrary angle θ. A tape wire 3 is helically and closely wound around the bobbin at an arbitrary helical winding angle γ from one end of the drum 1, as shown in FIG. 2. In this case, when adjoining turns of the tape wire 3 overlap with each other, the tape wire 3 is locally raised at the overlapping position. This disturbs electromagnetic waves and adversely affects the coil characteristics. Therefore, it is necessary to take care so that the turns of the tape wire 3 do not overlap.

In this case, the following relational expressions hold:

$$P = W/\sin\alpha$$

$$\pi D = P\tan\alpha = (W/\sin\alpha) \times (\sin\alpha/\cos\alpha) = W/\cos\alpha$$

$$\therefore \cos\alpha = W/\pi D, \text{ that is, } \alpha = \arccos(W/\pi D)$$

where D represents the outer diameter of the drum 1, W represent the width of the tape wire 3, P represents the helical

pitch, and $\alpha$ represents the helical winding angle. That is, the condition that $\alpha = \arccos (W/\pi D)$ is desirable for close winding.

When a spacer is disposed between the adjoining turns of the tape wire 3 for insulation, the above-described width W is the sum of the width of the wire 3 and the width of the spacer.

With the above-described helical winding structure, the tape wire 3 can be smoothly and helically wound around the drum 1.

However, as pointed out in the description of the related art, the tapered portions 2 shown in FIG. 1 are not provided at the leading ends of the drum in the known solenoid coil. Therefore, when a layer is formed by helically winding a tape wire from one end to the other end of the drum and the tape wire is then wound back in the opposite direction to form a layer on the formed layer, it is quite troublesome and difficult to adjust the helical winding angle for the winding-back operation. In addition, it is necessary to fold the tape wire in a three-dimensional complicate manner in order to adjust the helical winding angle. Superconductivity is considerably reduced at the folded portion. Moreover, since a considerable length of wire is needed for every winding-back operation, waste of the tape wire is not negligible.

In contrast, the bobbin of this embodiment has the tapered portions 2 extending from both ends of the drum 1, and therefore, the above-described winding-back operation can be performed smoothly and easily, as will be described below. FIG. 2 is a conceptual view showing a state in which the tape wire 3 is wound back onto the drum 1 at the tapered portion 2. In FIG. 2, the principal parts are partially enlarged. The right side of FIG. 2 is a developed explanatory view showing a state in which the tape wire 3 is wound back again onto the drum 1 along the tapered portion 2.

As shown in this figure, after the tape wire 3 is helically wound around the drum 1 and comes from the end of the drum 1 to the tapered portion (inclined face) 2, it is also closely wound around the tapered portion 2. Consequently, the tape wire 3 is wound in tight contact with the tapered portion 2 while changing the winding direction in accordance with the inclination angle of the tapered surface.

The tapered surface of the tapered portion 2 is symmetrical with respect to the center line AO of the bobbin, as shown in the developed explanatory view on the right side of FIG. 2. Therefore, while the tape wire 3 is wound around the drum 1 to the tapered portion 2 at a helical winding angle $\alpha$, it is wound back from the tapered portion 2 to the drum 1 at a helical winding angle $-\alpha$ opposite to the helical winding angle $\alpha$. The tape wire 3 is then helically wound around the drum 1 at the helical winding angle $-\alpha$ to form a subsequent layer.

After the tape wire 3 is helically wound and reaches the left end of the drum 1, it is wound in tight contact with the tapered portion 2, and the helical winding direction (angle) is naturally changed from $-\alpha$ to $\alpha$. The tape wire 3 is then wound around the drum 1 at the helical winding angle $\alpha$, similarly to the above.

By thus repeating the above-described winding-back operation of the tape wire 3 at both ends of the drum 1 along the tapered portions 2, the tape wire 3 can be smoothly wound back to form subsequent layers in an orderly and close manner while minimizing the length necessary for winding back and without irregularly raising the tape wire 3 at the ends. Moreover, distortion of the tape wire 3 is caused only by a slight difference in inclination angle between the surfaces of the drum 1 and the tapered portions 2 in the winding-back operation. Therefore, distortion itself can be minimized. When the inclination angle is designed to be smaller, the length of the portions of the tape wire 3 wound around the tapered portions 2 becomes slightly larger, but distortion at the wound-back portions is reduced further.

The bobbin according to the embodiment of the present invention is characterized in that the tapered portion is provided at each end of the drum, as described above. The diameter and length of the drum 1 and the inclination angle and length of the tapered portions 2 are not limited, and may be arbitrarily changed as required. The materials of the drum 1 and the tapered portions 2 are also not limited, and any materials can be adopted as long as they have an appropriate structural strength and do not adversely affect superconductivity.

When a precursor of an oxide superconducting wire is wound with this bobbin before oxidation heating and an oxide superconducting coil is produced by a react-and-wind technique, it is required to perform oxidation heating after winding. Therefore, a heat-resistant and oxidation-resistant material, such as a ceramic, which can endure oxidation heating is used, and slits or vent holes can be provided in the drum or the drum can be formed of a meshed member so that oxidation heating can efficiently proceed from the interior.

The use of the bobbin according to the embodiment can minimize distortion of the tape wire when the wire is wound back. Therefore, even when an oxide superconducting wire is used, it can be continuously and solenoidally wound in multiple layers without causing breakage and cracking as long as it is relatively thin.

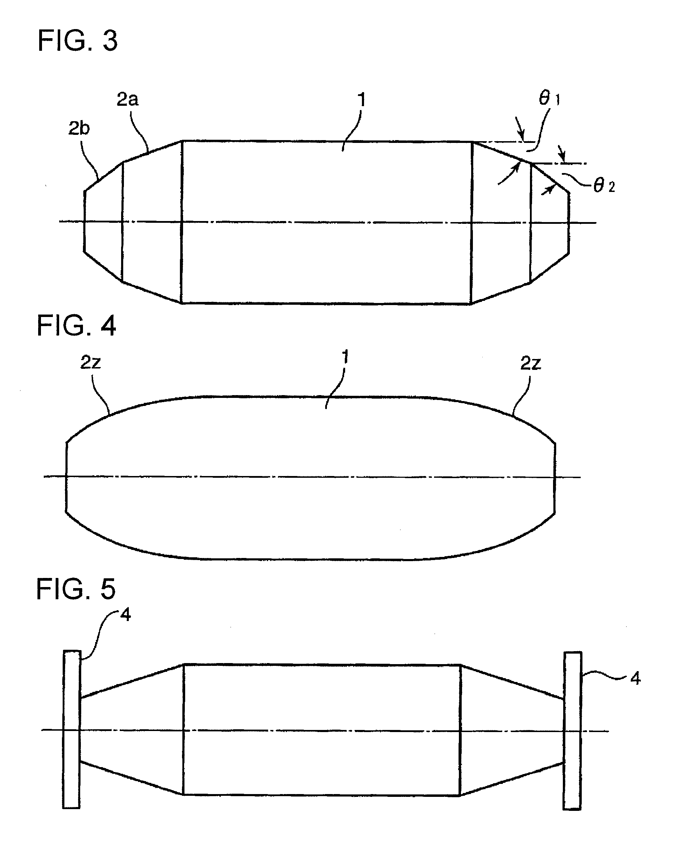

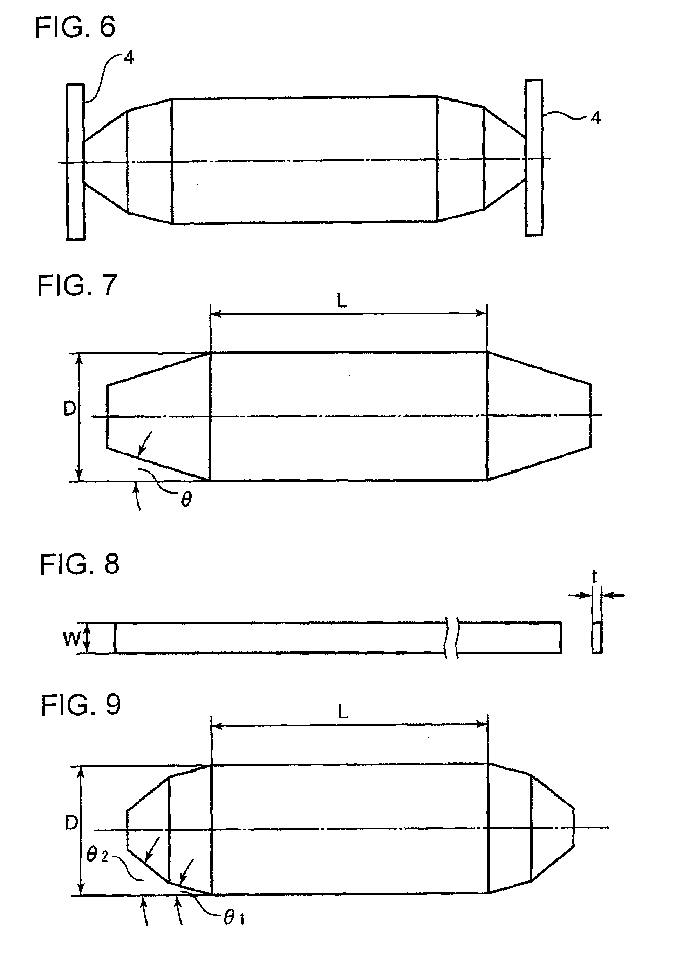

While the tapered surface of the tapered portion 2 is inclined at a constant angle in the above-described embodiment, for example, it may be formed by two or more inclined faces (two inclined faces 2a and 2b in FIG. 3) so that the inclination angle increases toward the tip of the tapered portion 2, as shown in FIG. 3. This is preferable because distortion of the tape wire caused when the wire is wound around the inclined faces can be reduced further. Alternatively, when the tapered surface is a curved face 2z whose inclination angle varies in a stepless manner, as shown in FIG. 4, distortion can be reduced further. As shown in FIGS. 5 and 6, a flange 4 may be provided at an end of each tapered portion 2.

The above-described bobbin of the embodiment has a simple structure, as shown in the figures. In brief, a tapered portion extends from each end of a drum having arbitrary dimensions (diameter and length), and has a tapered surface that is inclined at an arbitrary angle. By a simple operation of winding back a tape wire, which is helically wound around the drum, in contact with the tapered portions, the wire can be smoothly wound to form subsequent layers while minimizing distortion of the wire caused at the wound-back portions.

The type of the superconducting wire (or a precursor thereof) solenoidally wound around the bobbin is not particularly limited, and all oxide superconducting wires and metal superconducting wires can be used. Examples of oxide superconducting wires are bismuth oxide superconducting wires formed of Bi-2212 ($Bi_2Sr_2Ca_1Cu_2O_y$) and Bi-2223 ($Bi_2Sr_2Ca_2Cu_3O_y$), and other various oxide superconducting wires made including YBCO ($YBa_2Cu_3O_x$) and oxide superconducting wires disclosed in Japanese Unexamined Patent Application Publication No. 2003-115225. Examples of metal superconducting wires are superconducting wires formed of $Nb_3Sn$, NbTi, $Nb_3Al$, NbZr, $MgB_2$, and $V_3Ga$.

Since a metal superconducting wire itself has moderate flexibility, it can be continuously and solenoidally wound around the bobbin according to the embodiment in multiple layers without any problem. A precursor of an oxide superconducting wire can also be solenoidally wound around the bobbin in a deformable state. Even when an oxide superconducting wire having low deformability is used, it is applicable to both a wind-and-react technique and a react-and-wind technique, as described above, because distortion of the wire caused by winding back can be minimized.

In the coil formed by solenoidally winding the superconducting tape wire around the bobbin, the wire closely wound around the drum in multiple layers can form a highly uniform magnetic field in a region with a certain length extending in the axial direction of the drum, and can achieve superior performance as a superconducting coil for use in analysis and medical care such as nuclear magnetic resonance analysis and magnetic resonance imaging.

While the configuration and operational advantages of the present invention will be specifically described below in conjunction with examples, it should be noted that the invention is not limited to the following examples, that appropriate modifications can be made without departing from the above- and below-described scope of the invention, and that the modifications are included in the technical range of the invention.

First Example

A tape wire having a width W of 10 mm and a thickness t of 0.2 mm shown in FIG. 8 was closely and solenoidally wound around a bobbin having an outside diameter D of a cylindrical portion of 80 mm, a length L of 500 mm, and a taper angle θ of 30° at a helical winding angle α of 88° so that adjoining turns of the wire did not overlap with each other. The wire was wound from an end of the cylindrical portion to a tapered portion at an angle of 88° to form a first layer, and was wound back in tight contact with the tapered portion. The tape was then wound around the cylindrical portion at 88° in a direction opposite to that for the first layer, thereby forming a second layer. Consequently, the wire could be smoothly wound back to form the second layer while being in tight contact with the tapered portion.

Second Example

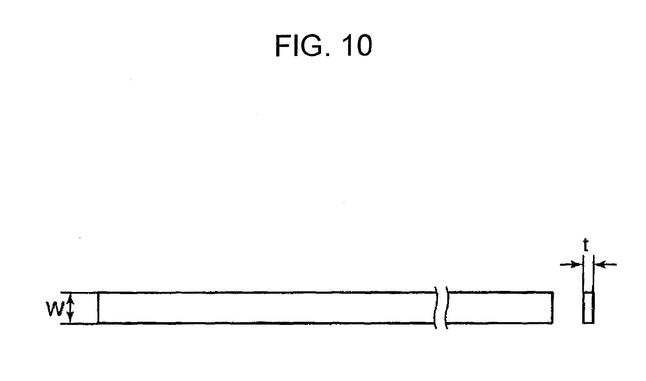

A tape wire having a width W of 10 mm and a thickness t of 0.2 mm shown in FIG. 10 was closely and solenoidally wound around a bobbin having an outside diameter D of a cylindrical portion of 80 mm, a length L of 500 mm, a taper angle $θ_1$ of 10°, and a taper angle $θ_2$ of 30° at a helical winding angle α of 88° so that adjoining turns of the wire did not overlap with each other. The wire was wound from an end of the cylindrical portion to a first tapered portion at an angle of 88° to form a first layer, was wound back in tight contact with the first tapered portion and a second tapered portion, and was then wound around the cylindrical portion at 88° in a direction opposite to that for the first layer, thereby forming a second layer. Consequently, the wire could be smoothly wound back in tight contact with the tapered portions to form the second layer.

When the wire is solenoidally wound in multiple layers, the coil diameter gradually increases, and the winding angle with respect to the tapered portion slightly varies. However, since the function of the tapered portion does not change, multilayer winding can be performed without any problem.

According to the following specifications, a tape-like superconducting wire formed of Bi2223 ($Bi_2Sr_2Ca_2Ca_3O_y$) was solenoidally wound around a bobbin of stainless steel with the same solenoid structure described in the first and second examples:

Specifications of Solenoidal Winding

Inner diameter: 80 mm, outer diameter: 80.8 mm, length: 500 mm, turns/layer: 49, number of layers: 2, number of turns: 98

Subsequently, the obtained solenoid coil was impregnated with epoxy resin to fix the windings, and was then subjected to an excitation test in liquid helium at 4.2 K. As a result, a current of 1000 A could be passed, and a magnetic field of 0.24 T was produced.

Then, the solenoid coil was inserted in an inner layer of a metal superconducting magnet that could produce a magnetic field of 17 T in a cylindrical space having a diameter of 100 mm, and an excitation test was conducted in a background magnetic field of 17 T. In this case, the operating temperature was set at 4.2 K. As a result, a current of 400 A could be passed, and a magnetic field of 0.097 T was produced. The sum of the produced magnetic field and the background magnetic field was 17.097 T.

A bobbin for a superconducting coil includes a cylindrical drum, and a tapered portion extending from each end of the drum. A superconducting wire or a precursor of the superconducting wire shaped like a tape is helically wound around the drum in multiple layers. The tapered portion has a tapered surface that is inclined at an arbitrary angle.

**Claims**

1.  A bobbin for a superconducting coil, comprising:

    a drum around which a superconducting wire or a precursor of the superconducting wire is helically wound in multiple layers; and
    a tapered portion extending from each end of the drum,

    wherein the superconducting wire or the precursor is shaped like a tape, and
    wherein the tapered portion has a tapered surface that is inclined at an arbitrary angle such that a diameter of the tapered portion decreases toward a tip thereof.

2.  The bobbin according to claim 1, wherein the tapered surface is inclined at a constant angle.

3.  The bobbin according to claim 1, wherein the tapered surface includes a plurality of inclined faces such that an inclination angle of the tapered surface increases stepwise.

4.  The bobbin according to claim 1, wherein the tapered surface is a curved face such that an inclination angle of the tapered surface increases continuously.

5.  A solenoid coil comprising:

    a superconducting wire or a precursor of the superconducting wire shaped like a tape and helically wound in multiple layers around the drum of the bobbin according to any of claims 1 to 4,

    wherein the superconducting wire or the precursor is wound back along the tapered portion by being wound in contact with the tapered portion, and
    wherein a helical winding angle of the superconducting wire or the precursor is changed from $\alpha$ to $-\alpha$ when the superconducting wire or the precursor is wound back.

# FIG. 1

# FIG. 2

FIG. 3

FIG. 4

FIG. 5

FIG. 6

FIG. 7

FIG. 8

FIG. 9

# FIG. 10

**European Patent Office**

**EUROPEAN SEARCH REPORT**

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | GB 584 375 A (HENRY KREMER) 14 January 1947 (1947-01-14) * page 1, lines 69-89 * * page 3, lines 4-17 * * page 3, lines 28-30; figure 2 * ----- | 1,2 | INV. H01F6/06 H01F41/06 G01R33/3815 |
| A | GB 662 691 A (ALADDIN IND INC) 12 December 1951 (1951-12-12) * page 3, lines 23-39; figure 4 * ----- | 1,4 | |
| A | WO 94/13992 A (ROYAL ORDNANCE PLC [GB]; MILLWARD WILLIAM ANTHONY [GB]; DABINETT JOHN) 23 June 1994 (1994-06-23) * claims 1-6 * ----- | 5 | |
| A | EP 0 350 267 A1 (GEN ELECTRIC [US]) 10 January 1990 (1990-01-10) * page 11, lines 26-33; figures 26-28 * ----- | 1,4,5 | |
| A | US 2005/040725 A1 (SUZUKI YUZURU [JP]) 24 February 2005 (2005-02-24) * paragraphs [0058], [0059]; figure 3 * ----- | 1,4,5 | TECHNICAL FIELDS SEARCHED (IPC) |
| A | JP 61 082404 A (TOKYO SHIBAURA ELECTRIC CO) 26 April 1986 (1986-04-26) * abstract * ----- | 1 | H01F G01R |

The present search report has been drawn up for all claims

| Place of search | Date of completion of the search | Examiner |
|---|---|---|
| Munich | 6 March 2007 | VAN DEN BERG, G |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 06 11 8738

This annex lists the patent family members relating to the patent documents cited in the above-mentioned European search report.
The members are as contained in the European Patent Office EDP file on
The European Patent Office is in no way liable for these particulars which are merely given for the purpose of information.

06-03-2007

| Patent document cited in search report | | | Publication date | Patent family member(s) | | | Publication date |
|---|---|---|---|---|---|---|---|
| GB 584375 | A | | 14-01-1947 | NONE | | | |
| GB 662691 | A | | 12-12-1951 | NONE | | | |
| WO 9413992 | A | | 23-06-1994 | AT | 163216 | T | 15-02-1998 |
| | | | | AU | 667610 | B2 | 28-03-1996 |
| | | | | AU | 5572994 | A | 04-07-1994 |
| | | | | CA | 2129636 | A1 | 23-06-1994 |
| | | | | CN | 1093785 | A | 19-10-1994 |
| | | | | DE | 69316975 | D1 | 19-03-1998 |
| | | | | DE | 69316975 | T2 | 10-06-1998 |
| | | | | DK | 625251 | T3 | 11-05-1998 |
| | | | | DZ | 1734 | A1 | 17-02-2002 |
| | | | | EP | 0625251 | A1 | 23-11-1994 |
| | | | | ES | 2112512 | T3 | 01-04-1998 |
| | | | | JP | 3735113 | B2 | 18-01-2006 |
| | | | | JP | 8504020 | T | 30-04-1996 |
| | | | | RU | 2121101 | C1 | 27-10-1998 |
| | | | | US | 5579809 | A | 03-12-1996 |
| | | | | US | 5636878 | A | 10-06-1997 |
| | | | | US | 6048428 | A | 11-04-2000 |
| EP 0350267 | A1 | | 10-01-1990 | DE | 68907278 | D1 | 29-07-1993 |
| | | | | DE | 68907278 | T2 | 17-02-1994 |
| | | | | IL | 90671 | A | 29-03-1992 |
| | | | | JP | 1992184 | C | 22-11-1995 |
| | | | | JP | 2065204 | A | 05-03-1990 |
| | | | | JP | 5061762 | B | 07-09-1993 |
| | | | | US | 4924198 | A | 08-05-1990 |
| US 2005040725 | A1 | | 24-02-2005 | JP | 2005073344 | A | 17-03-2005 |
| JP 61082404 | A | | 26-04-1986 | NONE | | | |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2001332415 A
- JP 10289817 A
- JP H10289817 A
- JP 2003115225 A